Europäisches Patentamt

European Patent Office

Office européen des brevets

(19)

(11) EP 1 075 716 B1

(12) EUROPEAN PATENT SPECIFICATION

(45) Date of publication and mention
of the grant of the patent:
**28.07.2004 Bulletin 2004/31**

(51) Int Cl.7: **H01S 5/343**

(86) International application number:
**PCT/SE1999/000771**

(21) Application number: **99953406.8**

(22) Date of filing: **07.05.1999**

(87) International publication number:
**WO 1999/062153 (02.12.1999 Gazette 1999/48)**

(54) **InP-BASED MQW-LASER**

InP-BASIERTER MQW-LASER

LASER InP A PUITS QUANTIQUES MULTIPLES

(84) Designated Contracting States:
**DE ES FI FR GB IT NL SE**

(30) Priority: **08.05.1998 SE 9801608**

(43) Date of publication of application:
**14.02.2001 Bulletin 2001/07**

(73) Proprietor: **Telefonaktiebolaget LM Ericsson (publ)**
**164 83 Stockholm (SE)**

(72) Inventors:
• **LANDGREN, Gunnar**
**S-192 70 Sollentuna (SE)**

• **SILFVENIUS, Christofer**
**S-112 64 Stockholm (SE)**

(74) Representative: **Sjöberg, Mats Hakan**
**Ericsson AB**
**Patent Unit Core Networks Kista**
**164 80 Stockholm (SE)**

(56) References cited:
• **JOURNAL OF CRYSTAL GROWTH SILFVENIUS CHRISTOFER ET AL: 'MOVPE Growth of Strain-Compensated 1300nm In1-xgaxasyp1-y Quantum Well Structures' vol. 170, no. 1-4, 01 January 1997, THE NETHERLANDS, pages 122 - 126, XP004087089**

## EP 1 075 716 B1

**Description**

The present invention relates to a semiconductor laser of the kind defined in the preamble of Claim 1.

Semiconductor lasers of this general kind have been known for a relatively long time and the basic principle of such lasers will be apparent from the monograph "Long Wavelength Semiconductor Lasers" by G.P. Agrawal and N.K. Dutta (New York 1986).

It has been possible to produce MQW-type (Multiple Quantum Well) semiconductor lasers for the wavelength band 1.55 µm, which is of interest in the communications field (optical fibres). However, in the case of the wavelength band 1.3 µm, which is also of interest, no practical types of laser have been proposed that will function without being cooled. An object of the invention is to rectify this deficiency.

Such lasers are required to function uncooled at relatively high powers and modulation rates. This implies low threshold current values that preferably do not rise with increasing ambient temperatures. This requires minimal radiation-free transitions, Auger transitions being normal in this respect. One factor in this regard is that the different well layers shall be able to take-up the same number of holes and electrons without an exaggerated collection of holes in the wells closest to the p-contact, in turn attracting electrons to the same wells. The non-radiating recombination (e. g. the Auger recombination) namely rises much more rapidly than linear as a function of the charge carrier density, whereas the increase in light amplification is lower than linear with density. Consequently, one should strive for uniform carrier distribution between the wells.

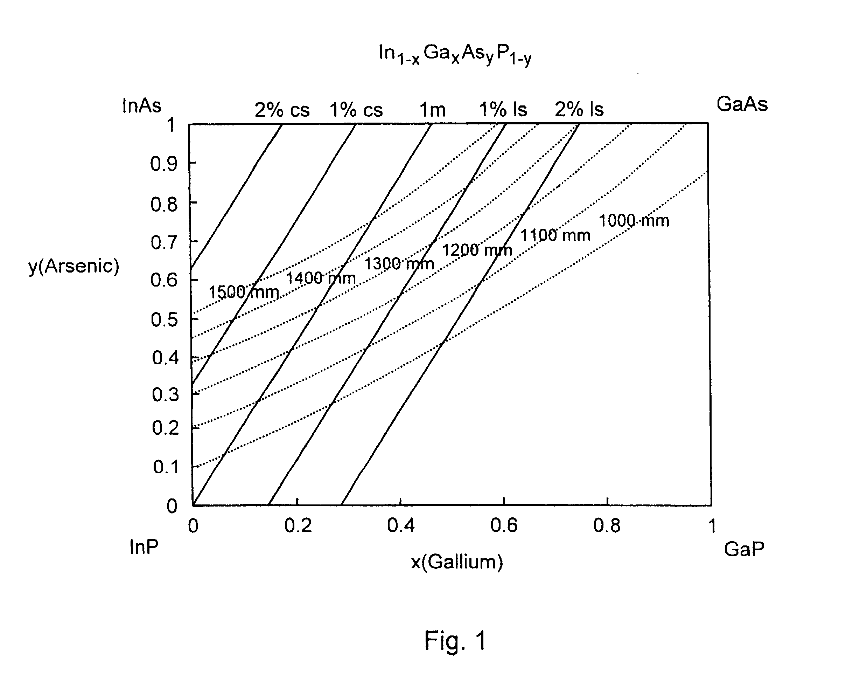

The crystalline substances concerned in this regard are substances that include a mixture of group 3 atoms and group 5 atoms: $In_{1-x}Ga_xAS_yP_{1-y}$ or $In_{1-x-z}Ga_xAl_zAS_yP_{1-y}$. Fig. 1 is a diagrammatic illustration of the former combination, in which dotted-line curves show the energy gap expressed in a wavelength measurement in a bulk alloy as a function of x and y (in thin layers in the configuration relevant in respect of MQW-lasers, the wavelength will be shorter due to the quantised energy states in the wells present in the conduction and valence bands).

The full lines in Fig. 1 denote equilines for lattice constants of equal size, namely such that the line which passes from origo to lm (lattice matched) signifies compositions that have the same lattice constant as a substrate of indium phosphide (InP). Those lines to the left of this line, reference 1% cs and 2% cs, show reduced lattice constants, also called compressive (constrictive) in relation to the substrate, whereas the line to the right of said line signifies corresponding extended or increased lattice constants, called tensile. It will be realised, and is also well known, that epitaxial crystal growth is not possible between layers where the difference in lattice constant is excessively large (also called mismatching), while retaining single crystalinity - a rule of thumb is that a difference of 20 nm% should not be exceeded, in other words the layer thickness measured in nm and multiplied by the mismatch in percent (strain) should be kept beneath this value. The reason why one no longer sticks to the lattice-match line hangs together with improved theoretical laser properties in MQW-lasers having lattice mismatch wells, due to the separation of heavy and light holes in the valence band and the change in the hole masses that cause the state density in the valence band to approach the state density in the conduction band, which leads to the requirement of reduced inversion.

A well known solution with respect to MQW-lasers for the 1.55 µm band is to place both the well layers and barrier layers on a horizontal line in accordance with the Fig. 1 diagram, with opposing 1% mismatches. Tests have shown that a corresponding placement, on a lower arsenic level, is unsuccessful by virtue of being unable to detect any layers in X-ray diffraction, therewith excluding the use of such material for an MQW-laser.

The invention solves the aforesaid problem by arranging the well layers and barrier layers of an InP-based MQW-laser of the aforesaid kind in accordance with the characterising clause of Claim 1. Further embodiments of the invention will be apparent from the dependent Claims.

It will be understood that the manufacturing methods used and available at present are generally encumbered with serious difficulties with respect to precision. The quantitative magnitudes recited herein shall not therefore be considered to be more precise than what is meaningful in relation thereto, therewith bestowing an explanation and definition of the word "essentially" or "generally" as used in this document.

### BRIEF DESCRIPTION OF THE DRAWINGS

As before mentioned, Fig. 1 is a graphic illustration of the InGaAsP system and shows how the lattice constant and energy gap respectively vary with different compositions in bulk.

Fig. 2 illustrates schematically and in section an MQW-laser with the thickness shown along the X-axis and the energy gap shown along the Y-axis.

Fig. 3 illustrates the influence of the effective heavy-hole well depth on the lasering threshold current and the optical power output.

## DETAILED DESCRIPTION OF PREFERRED EMBODIMENTS

The invention will now be described in more detail with reference to illustrative examples thereof.

Manufacture of epitaxial layers of the kind meant here is well known and will not therefore be described in great detail. Gaseous compounds of the various substances are passed at a low pressure (normally 20-100 mbar, in the present case 50 mbar) over a monocrystalline InP substrate towards the plane <100> heated to about 700°C (standard method temperature of 600-700°C), wherewith the gases are decomposed and the relevant atoms released so as to build up a layer which follows the existing crytalline lattice. According to MOVPE (Metal Organic Vapour Phase Epitaxy) there is used phosphine ($PH_3$), arsine ($AsH_3$) and TMIn, TMGa and possibly TMA1, entrained in a hydrogen gas flow.

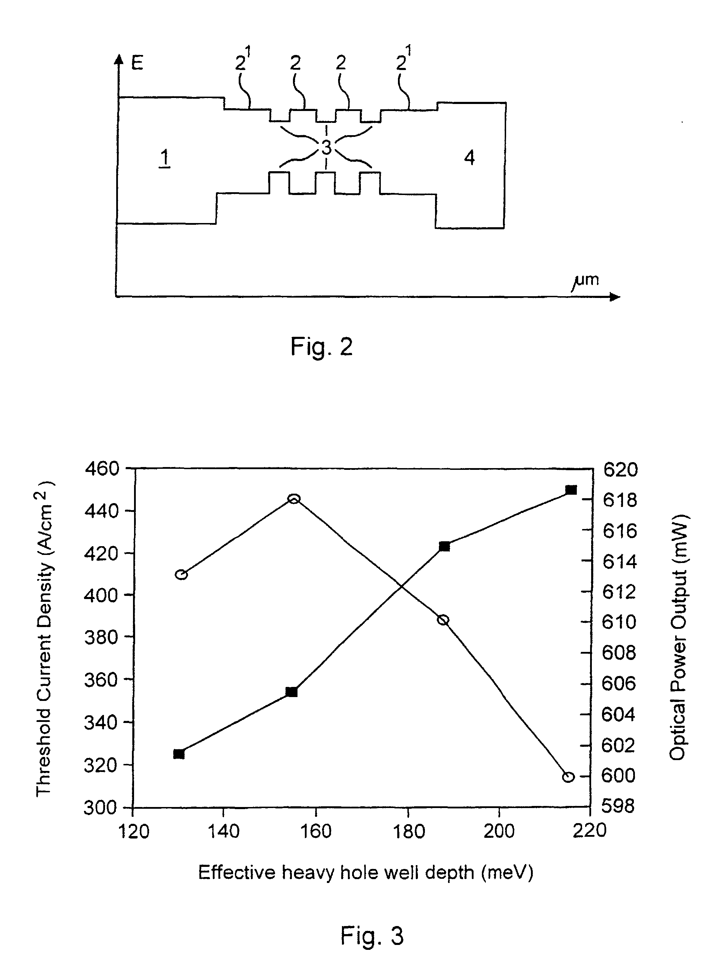

Fig. 2 illustrates schematically one such epitaxial structure, where the substrate 1 has been doped to either p-conduction or n-conduction, and successive barrier layers 2 and well layers 3 are provided for connection with an electrode layer 4 of opposite conduction to the substrate. Although the X-axis has been given a length measurement, the axis is not according to scale. For instance, the wells may be very thin, e.g. 6.5 nm, and the barrier layers will be normally thicker, e.g. 8 nm. The outermost barriers 2' may have a much greater thickness, e.g. a thickness of 100 nm, and function as optical waveguides through the medium of a high optical refractive index, which encloses the optical field across the wells, i.e. the active area.

EXAMPLE

As before mentioned, according to the invention combinations of respective wells and barriers are used that have mutually the same content of groups-III atoms, while varying the content of group-V atoms. The system shown in Fig. 1 was used in a test series, with x = 0.10 and y = 0.52 in the wells. y was varied between 0.08 and 0.22 in several stages in the barriers.

It was possible to show in earlier tests with the aid of high resolution, X-ray diffraction and photoluminescence that it is not possible to obtain a good structure with a constant content of group-V atoms and a varying content of group-III atoms (horizontally situated points in Fig. 1), which according to known technology functions well within the 1.55 µm wavelength range. On another occasion, a test was run with a constant content of group-III atoms, x = 0.1, y = 0.52 in respect of the wells, x = 0.1, y = 0 in respect of the barriers, and a particularly good structure was established in X-ray diffraction and also in photoluminescence from the well package, although the lasers still exhibited very low internal efficiencies.

Lasers having a width of 50 µm and lengths of 300-1200 µm with mirrors in the form of cleaved surfaces were produced from the coated substrates. The hole confinement energy in respect of heavy holes in the wells could be varied between 130 and 215 meV, by changing the barrier composition while maintaining the same well composition. Lasers having 5, 8 and 12 well layers were produced at a hole confinement energy of 130 meV, otherwise lasers having five well layers were produced. The results are evident from Table 1.

In the table, the first row and the third from the end refer to the same laser. The constant To is a measurement of the thermal drift of the threshold current according to the idealised relationship

$$I \propto \exp T/T_0$$

calculated for different temperature ranges.

Table 1

| Calc. hole depth | Number of well layers | Internal efficiency | Internal losses/? | Threshold density at infinite? | $T_0$ 20-60°C | $T_0$ 20-80°C |
|---|---|---|---|---|---|---|
| [meV] | | [%] | [%] | (A/cm$^2$/well] | [K] | [K] |
| 130 | 5 | 85 | 9.7 | 65 | 83 | 67 |
| 154 | 5 | 97 | 11.8 | 71 | 74 | 67 |
| 186 | 5 | 77 | 7 | 85 | 66 | 63 |
| 215 | 5 | 38 | 9 | 90 | 60 | 58 |
| 130 | 5 | 85 | 9.7 | 65 | 83 | 67 |
| 130 | 8 | 89 | 13 | 63 | 67 | 70 |
| 130 | 12 | 98 | 23 | 60 | 77 | 79 |

It is evident that the barrier height, which determines the calculated well depth of the holes, is highly significant to the result and it is preferred to keep the barrier height as low as possible in practice and at least beneath 170 meV, although it should not be too low either, since the advantage of having wells would then disappear and the laser would begin to liken a bulk laser. As will be evident from Fig. 3, which shows with solid squares the threshold density for laser action in A cm$^{-2}$ (the scale to the left) and with circles the optical power output in mW (the scale to the right) at otherwise equal test conditions (mW) as functions of effective hole well depth in meV.

Hole transport times across the well package can be measured in a manner described by Tessler et al, "Vertical carrier transport in InGaAsP Multiple-quantum - Well Laser Structures: Effect of p-doping", IEEE Journ. Of Selected Topics in Quant. Electron., Vol. 3, No. 2, pp. 315-319. It is well known that the total transfer velocity of the charge carriers is determined by the hole dynamics.

It has been found possible to obtain extremely good geometric properties with respect to the well and barrier layers by means of the inventive MQW-laser, and also well-functioning barrier conditions that are directed towards suppressing tendencies towards radiation-free transitions, so-called Auger effects, and low lasering threshold current densities, these factors both contributing towards high efficiency and low losses, such as to enable controllable laser light sources to be driven at usable intensities without special cooling, even in the wavelength band around 1.3 $\mu$m. It is assumed that the good result is due to the combination of lattice-mismatched wells having relatively high electron confinement energy (which is highly significant with respect to high temperature properties where it is the electrons that can leave the well most easily due to thermal escape) and optimisation of a uniform charge distribution across the well packet, achieved by practical tests that have been able to ensure a high material quality. This results in lasers that have low internal losses and thus low threshold currents, and a threshold current that is temperature-stable.

It will be understood that the invention is not restricted to the exemplified embodiment thereof and that the scope of the invention is restricted solely by the contents of the following Claims.

## Claims

1.    An InP-based multiple quantum well MQW-laser including the group-III elements In, Ga and possibly Al, and the group-V elements P and As and operating in the 1.3 $\mu$m band and built-up on an InP-substrate (1) and having at least one epitaxial well layer (3) with a lattice constant mismatch in relation with the substrate (1) in sandwich formation with barrier layers (2,2') that have a larger energy gap than said well layers (3), wherein said well layers (3) have an energy transition from a first quantised state in its conduction band to a first quantised state in its valence band that corresponds to the laser wavelength, and wherein said well layer (3) and barrier layers (2,2') have essentially the same group III-element content, **characterised in that** the mismatch of the barrier layers (2,2') is tensile or lattice-adapted by variation of the group-V element content of the barrier layer (2,2') such that the effective hole barrier will be less than 170 meV and preferably less than 150 meV.

2.    An MQW-laser according to Claim 1, **characterised in that** the content of the group-III element Ga is 5-20%.

3.    An MQW-laser according to Claim 1 or Claim 2, **characterised in that** the content of group-III element Ga and/or Al is 5-20%.

4.    An MQW-laser according to Claim 1 or Claim 2, **characterised in that** the content of group-III element Ga is 10%.

5.    An MQW-laser according to Claim 1 or Claim 2, **characterised in that** the content of the group-III element Ga and/or Al is 10%.

6.    An MQW-laser according to any one of the preceding Claims, **characterised in that** the content of the group-V element As in the barriers lies between 8-22%.

7.    An MQW-laser according to any one of the preceding Claims, **characterised in that** it includes a plurality of well layers (3).

8.    An MQW-laser according to any one of the preceding Claims, **characterised in that** the mismatch of said well layer (3) in relation to the substrate (1) is greater than 0.5%.

# EP 1 075 716 B1

**Patentansprüche**

1.  InP-basierter Vielfach-Quantenschacht-MQW-Laser inkludierend die Elemente von Gruppe III In, Ga und möglicherweise Al, und die Elemente von Gruppe V P und As und betriebsfähig in dem Band von 1,3 μm und aufgebaut auf einem InP-Substrat (1) und mit mindestens einer epitaktischen Schachtschicht (3) mit einer Gitterkonstanten-Fehlanpassung in Bezug auf das Substrat (1) in einer Einlegungsformation mit Barriereschichten (2, 2'), die eine größere Energielücke als die Schachtschichten (3) haben, wobei die Schachtschichten (3) einen Energieübergang von einem ersten quantisierten Zustand in seinem Leitungsband zu einem ersten quantisierten Zustand in seinem Valenzband haben, der der Laserwellenlänge entspricht, und wobei die Schachtschicht (3) und Barriereschicht (2, 2') im wesentlichen den gleichen Elementinhalt von Gruppe III haben, **gekennzeichnet dadurch, dass** die Fehlanpassung der Barriereschichten (2, 2') durch Variation des Elementinhalts von Gruppe V der Barriereschicht (2, 2') dehnbar oder gitter-angepasst ist, derart, dass die effektive Lochbarriere kleiner als 170 meV und vorzugsweise kleiner als 150 meV sein wird.

2.  MQW-Laser nach Anspruch 1, **gekennzeichnet dadurch, dass** der Inhalt des Elements Ga von Gruppe III 5-20% ist.

3.  MQW-Laser nach Anspruch 1 oder Anspruch 2, **gekennzeichnet dadurch, dass** der Inhalt von Element Ga und/oder Al von Gruppe III 5-20% ist.

4.  MQW-Laser nach Anspruch 1 oder Anspruch 2, **gekennzeichnet dadurch, dass** der Inhalt von Element Ga von Gruppe III 10% ist.

5.  MQW-Laser nach Anspruch 1 oder Anspruch 2, **gekennzeichnet dadurch, dass** der Inhalt des Elements Ga und/oder Al von Gruppe III 10% ist.

6.  MQW-Laser nach einem beliebigen der vorangehenden Ansprüche, **gekennzeichnet dadurch, dass** der Inhalt des Elements As von Gruppe V in den Barrieren zwischen 8-22% liegt.

7.  MQW-Laser nach einem beliebigen der vorangehenden Ansprüche, **gekennzeichnet dadurch, dass** er eine Vielzahl von Schachtschichten (3) inkludiert.

8.  MQW-Laser nach einem beliebigen der vorangehenden Ansprüche, **gekennzeichnet dadurch, dass** die Fehlanpassung der Schachtschicht (3) in Relation auf das Substrat (1) größer als 0,5% ist.

**Revendications**

1.  Laser à puits quantiques multiples (MQW) à base de InP comprenant les éléments du Groupe III In, Ga et, éventuellement, Al, et les éléments du Groupe V P et As, et fonctionnant dans la bande des 1,3 μm, et réalisé sur un substrat en InP (1), et comportant au moins une couche de puits épitaxiale (3) avec une discordance.de constante de réseau par rapport au substrat (1) dans une formation en sandwich avec des couches de barrière d'arrêt (2, 2') qui ont une bande interdite plus grande que celle desdites couches de puits (3), dans lequel lesdites couches de puits (3) ont une transition d'énergie d'un premier état quantifié dans sa bande de conduction à un premier état quantifié dans sa bande de valence qui correspond à la longueur d'onde du laser, et dans lequel ladite couche de puits (3) et ladite couche de barrière d'arrêt (2, 2') ont essentiellement la même proportion d'éléments du groupe III, **caractérisé en ce que** la discordance des couches de barrière d'arrêt (2, 2') est extensible ou adaptée au réseau grâce à la variation de la proportion d'éléments du groupe V de la couche de barrière d'arrêt (2, 2'), de telle sorte que la barrière d'arrêt de trous efficace soit inférieure à 170 meV, et, de préférence, inférieure à 150 meV.

2.  Laser à puits quantiques multiples selon la revendication 1, **caractérisé en ce que** la proportion de l'élément du groupe III Ga est comprise entre 5 et 20%.

3.  Laser à puits quantiques multiples selon la revendication 1 ou la revendication 2, **caractérisé en ce que** la proportion de l'élément du groupe III Ga et/ou Al est comprise entre 5 et 20%.

4.  Laser à puits quantiques multiples selon la revendication 1 ou la revendication 2, **caractérisé en ce que** la proportion de l'élément du groupe III Ga est de 10%.

5. Laser à puits quantiques multiples selon la revendication 1 ou la revendication 2, **caractérisé en ce que** la proportion de l'élément du groupe III Ga et/ou Al est de 10%.

6. Laser à puits quantiques multiples selon l'une quelconque des revendications précédentes, **caractérisé en ce que** la proportion de l'élément du groupe V As dans les barrières d'arrêt est comprise entre 8 et 22%.

7. Laser à puits quantiques multiples selon l'une quelconque des revendications précédentes, **caractérisé en ce qu'**il comprend une pluralité de couches de puits (3).

8. Laser à puits quantiques multiples selon l'une quelconque des revendications précédentes, **caractérisé en ce que** la discordance de ladite couche de puits (3) par rapport au substrat (1) est supérieure à 0,5%.

Fig. 1

Fig. 2

Fig. 3